# EUROPEAN PATENT APPLICATION

(11) **EP 1 883 067 A1**
(43) Date of publication of application: **30.01.2008**
(21) Application number: 06117720.0
(22) Date of filing: 24.07.2006
(51) Int. Cl.: G10L 19/00, G10L 19/14

(54) **Method and apparatus for lossless encoding of a source signal, using a lossy encoded data stream and a lossless extension data stream**

(71) Applicant: DEUTSCHE THOMSON-BRANDT GMBH, 78048 Villingen-Schwenningen (DE)
(72) Inventor: Jax, Peter, 30539, Hannover (DE); Keiler, Florian, 30161, Hannover (DE); Niemeyer, Oliver, 30161, Hannover (DE); Kordon, Sven, 30173, Hannover (DE); Boehm, Johannes, 37081, Göttingen (DE)
(74) Representative: Hartnack, Wolfgang

(57) **Abstract**

The invention is related to lossless encoding of a source signal (S_{PCM}), using a lossy encoded data stream and a lossless extension data stream which together form a lossless encoded data stream (S_{ENC}) for said source signal, whereby lossless audio compression means audio coding with bit-exact reproduction of the original PCM samples at decoder output. The lossy encoding/decoding may be an mp3 coding/decoding. The invention uses an integer MDCT and frequency domain decorre-lation (16) and time domain de-correlation (16) for the residual signal of the base-layer lossy audio codec. The exploitation of side information from the lossy base-layer codec allows for reduction of redundancies in the gross bit stream, thus improving the coding efficiency of the lossy based lossless codec.

## Description

The invention relates to a method and to an apparatus for lossless encoding of a source signal, using a lossy encoded data stream and a lossless extension data stream which together form a lossless encoded data stream for said source signal.

### Background

In contrast to lossy audio coding techniques (like mp3, AAC etc.), lossless compression algorithms can only exploit redundancies of the original audio signal to reduce the data rate. It is not possible to rely on irrelevancies, as identified by psycho-acoustical models in state-of-the-art lossy audio codecs. Accordingly, the common technical principle of all lossless audio coding schemes is to apply a filter or transform for de-correlation (e.g. a prediction filter or a frequency transform), and then to encode the transformed signal in a lossless manner. The encoded bit stream comprises the parameters of the transform or filter, and the lossless representation of the transformed signal.
See, for example, J. Makhoul, "Linear prediction: A tutorial review", Proceedings of the IEEE, Vol.63, pp.561-580, 1975, T. Painter, A. Spanias, "Perceptual coding of digital audio", Proceedings of the IEEE, Vol.88, No.4, pp.451-513, 2000, and M. Hans, R.W. Schafer, "Lossless compression of digital audio", IEEE Signal Processing Magazine, July 2001, pp.21-32.

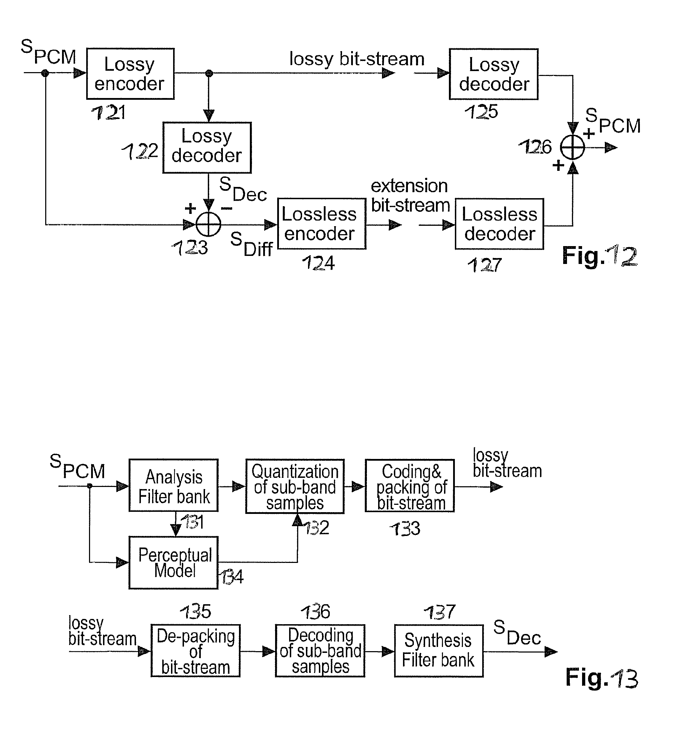

The basic principle of lossy based lossless coding is depicted in Fig. 12 and Fig. 13. In the encoding part on the left side of Fig. 12, a PCM audio input signal S_{PCM} passes through a lossy encoder 121 to a lossy decoder 122 and as a lossy bit stream to a lossy decoder 125 of the decoding part (right side). Lossy encoding and decoding is used to de-correlate the signal. The output signal of decoder 122 is removed from the input signal S_{PCM} in a subtractor 123, and the resulting difference signal passes through a lossless encoder 124 as an extension bit stream to a lossless decoder 127. The output signals of decoders 125 and 127 are combined 126 so as to regain the original signal S_{PCM}.
This basic principle is disclosed for audio coding in EP-B-0756386 and US-B-6498811, and is also discussed in P. Craven, M. Gerzon, "Lossless Coding for Audio Discs", J. Audio Eng. Soc., Vol. 44, No. 9, September 1996, and in J. Koller, Th. Sporer, K.H. Brandenburg, "Robust Coding of High Quality Audio Signals", AES 103rd Convention, Preprint 4621, August 1997.
In the lossy encoder in Fig. 13, the PCM audio input signal S_{PCM} passes through an analysis filter bank 131 and a quantisation 132 of sub-band samples to a coding and bit stream packing 133. The quantisation is controlled by a perceptual model calculator 134 that receives signal S_{PCM} and corresponding information from the analysis filter bank 131.
At decoder side, the encoded lossy bit stream enters a means 135 for de-packing the bit stream, followed by means 136 for decoding the subband samples and by a synthesis filter bank 137 that outputs the decoded lossy PCM signal S_{Dec}.
Examples for lossy encoding and decoding are described in detail in the standard ISO/IEC 11172-3 (MPEG-1 Audio).

In the state of the art, lossless audio coding is pursued based on one of the following three basic signal processing concepts:
a) time domain de-correlation using linear prediction techniques;
b) frequency domain lossless coding using reversible integer analysis-synthesis filter banks;
c) lossless coding of the residual (error signal) of a lossy base layer codec.

### Invention

A problem to be solved by the invention is to provide hierarchical lossless audio encoding and decoding, which is build on top of an embedded lossy audio codec and provides the same or a better efficiency (i.e. compression ratio) as compared to state-of-the-art lossy based lossless audio coding schemes, and which can be realised in more efficient way with respect to computational complexity. This problem is solved by the methods disclosed in claims 1 and 3. Apparatuses that utilise these methods are disclosed in claims 2 and 4, respectively.
Advantageous additional embodiments of the invention are disclosed in the respective dependent claims.

This invention uses a mathematically lossless encoding and decoding on top of a lossy coding. Mathematically lossless audio compression means audio coding with bit-exact reproduction of the original PCM samples at decoder output. For some embodiments it is assumed that the lossy encoding operates in a transform domain, using e.g. frequency transforms like MDCT or similar filter banks. As an example, the mp3 standard (ISO/IEC 11172-3 Layer 3) will be used for the lossy base layer throughout this description.

The transmitted or recorded encoded bit stream comprises two parts: the embedded bit stream of the lossy audio codec, and extension data for one or several additional layers to obtain either the lossless (i.e. bit-exact) original PCM samples or intermediate qualities.

The invention utilises features from concepts a), b) c), i.e. a synergistic combination of techniques from several ones of the state-of-the-art lossless audio coding schemes.

The invention uses frequency domain de-correlation, time domain de-correlation, or a combination thereof in a coordinated manner to prepare the residual signal (error signal) of the base-layer lossy audio codec for efficient lossless encoding.
Some embodiments additionally use information from the encoder of the lossy base-layer codec. The exploitation of side information from the lossy base-layer codec allows for reduction of redundancies in the gross bit stream, thus improving the coding efficiency of the lossy based lossless codec.
All embodiments have in common that at least two different variants of the audio signal with different quality levels can be extracted from the bit stream. These variants include the signal represented by the embedded lossy coding scheme and the lossless decoding of the original PCM samples. For some embodiments (see optional extensions 3 and 4 below) it is possible to decode one or several further variants of the audio signal with intermediate qualities (in the range limited by the lossy codec and mathematically lossless quality).

A special realisation is described were the MDCT part of a hybrid filter-bank is replaced or duplicated in a parallel data path by an integer MDCT, which makes redundant a full lossy decoding inside the lossless encoder block and thereby achieves a reduced computational complexity.

Furthermore, the invention allows for stripping of the embedded lossy bit stream using a simple bit dropping technique.
Some of the embodiments make it possible to efficiently re-code the embedded lossy bit stream, obtaining a new 'lossy' bit stream with a data rate that is different (lower or higher) from the original data rate of the embedded 'lossy' bit stream.

The invention is restricted to lossy core codecs that employ hybrid (analysis) filter-banks e.g. by utilising a sub-band filter-bank (like a polyphase filterbank) followed by an additional MDCT/DCT to increase the spectral resolution. This invention is especially useful if the sub-band filter bank is of a type where no special reversible integer realization is possible by techniques like decomposition into "Givens rotations" and "lifting steps", that is if a perfect mathematical reconstruction of an integer input signal by applying the analysis and synthesis sub-band filter-banks is impossible.

### Drawings

Exemplary embodiments of the invention are described with reference to the accompanying drawings, which show in:
- Fig. 1: general block diagram of a lossy based lossless encoder;
- Fig. 2: general block diagram of a lossy based lossless decoder;
- Fig. 3: block diagram of an mp3 encoder;
- Fig. 4: block diagram for a first embodiment encoder applied to the mp3 core codec;
- Fig. 5: block diagram for a first and second embodiment decoder;
- Fig. 6: block diagram for a second embodiment encoder;
- Fig. 7: block diagram for the first embodiment encoder with additional rounding gain factor processing;
- Fig. 8: block diagram for the first embodiment decoder with additional rounding gain factor processing;
- Fig. 9: block diagram for a decoder for the embedded mp3 bit stream;
- Fig. 10: block diagram for a decoder for the embedded mp3 bit stream plus frequency domain residual;
- Fig. 11: optional time de-correlation block or step for the encoder (left) and the decoder (right);
- Fig. 12: basic block diagram for a known lossy encoder and decoder;
- Fig. 13: basic block diagram for a known lossy based lossless encoder and decoder.

### Exemplary embodiments

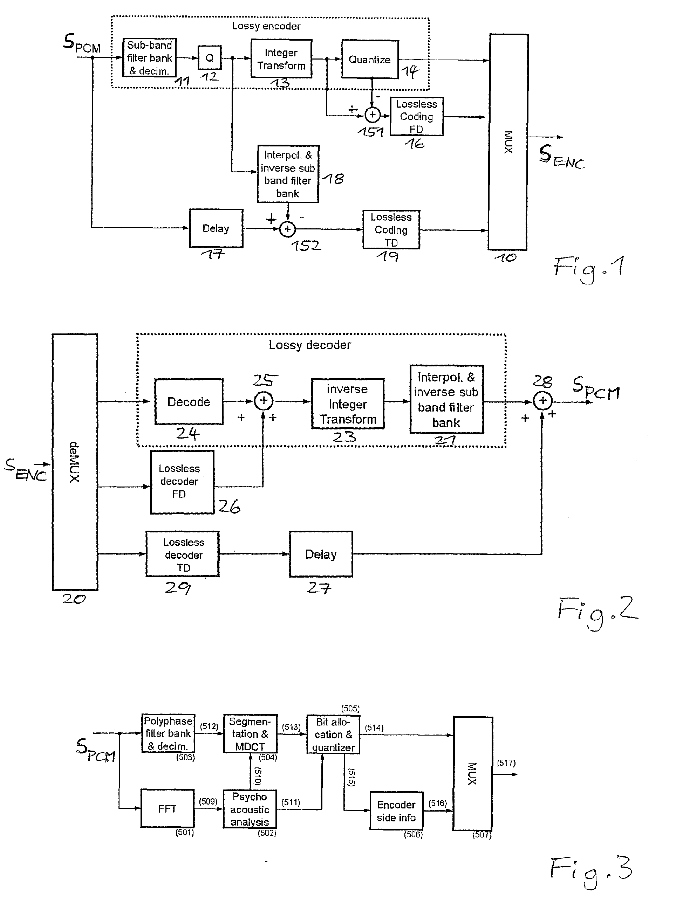

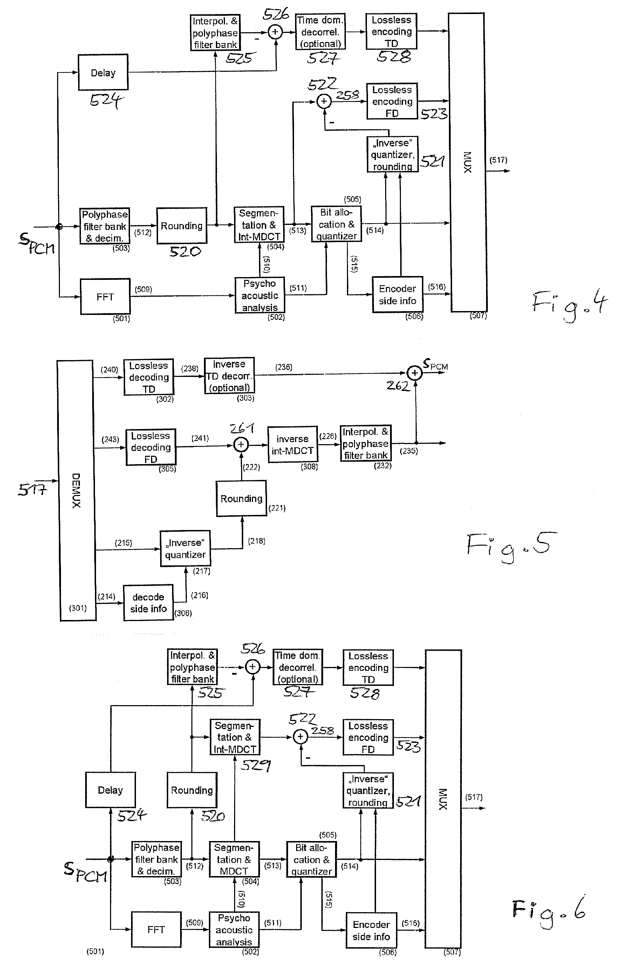

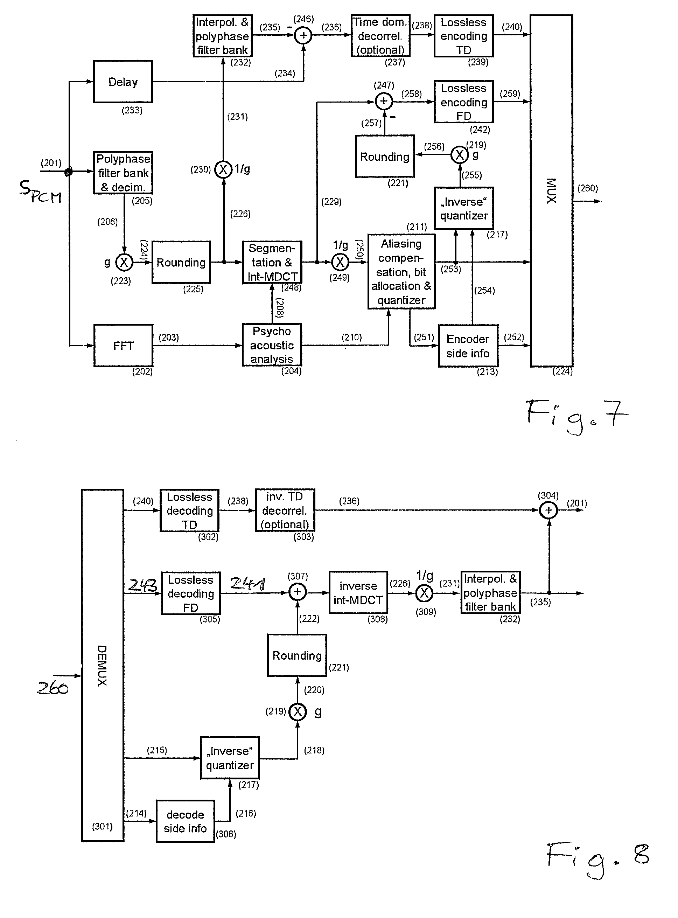

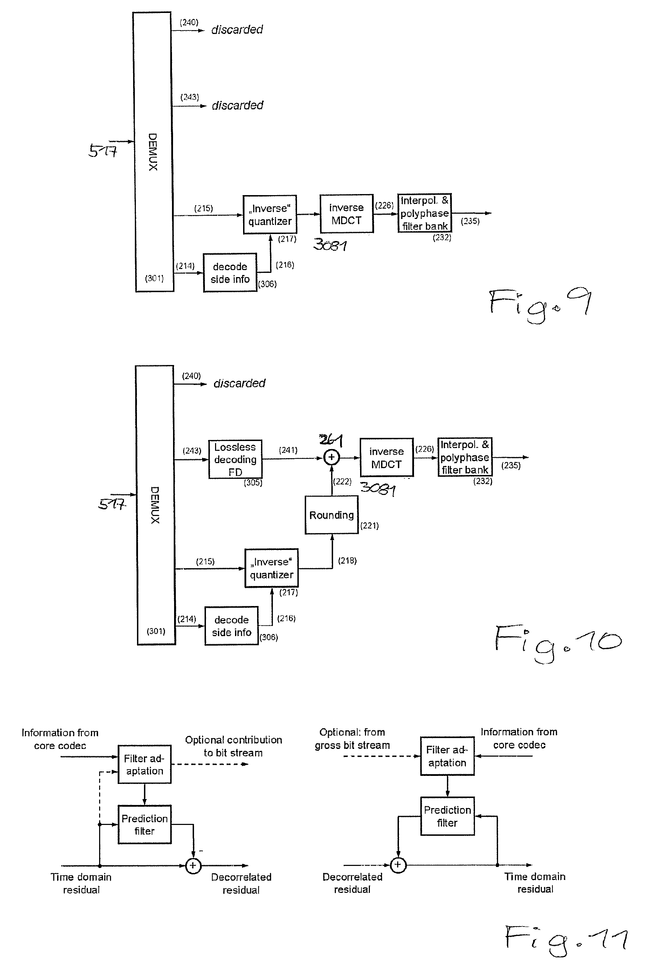

In the lossy based lossless encoder in Fig. 1, the PCM audio input signal S_{PCM} passes through a sub-band filter bank and decimator block or step 11, a first quantiser 12, an integer transform 13 and a second quantiser 14 to a multiplexer 10. This first quantiser 14 output provides index values representing the quantised values of the quantiser input signal, i.e. it codes the signal. The second output signal of quantiser 14 are the quantised input signal values which are subtracted (then representing the error in frequency domain) from the output signal of the integer transform block or step 13 in a first subtractor 151, the output signal of which passes through a lossless coding FD (frequency domain) block or step 16 to multiplexer 10. The output signal of the first quantiser 12 passes through an interpolation and inverse sub-band filter bank block or step 18 and is subtracted in a second subtractor 152 from the correspondingly delayed (delay 17) input signal S_{PCM}. The output signal of the second subtractor passes through a lossless coding TD (time domain) block or step 19 to multiplexer 10, which outputs a correspondingly multiplexed encoded bit stream S_{DEC}. Blocks/stages 11, 12, 13 and 14 together form a lossy encoder.

A transform following the analysis sub-band filter bank 11 inside the lossy encoder is replaced by a rounding/quantisation step 12 and an integer transform 13. Optional there can the be the original transform and a rounding/quantisation step followed by an integer transform as a parallel data path. Details on this option are described below. The integer transform approximates a conventional (floating-point) MDCT transform, but receives integer values at the input and produces integer values at the output. By decomposing the transform operations into a sequence of reversible 'lifting steps', the complete integer MDCT approximation can be reversed in a mathematically lossless manner.
In lossless audio coding schemes like in the MPEG SLS (scalable to lossless) standard, such integer MDCT transforms have been applied to the original time domain PCM samples. However, in this invention the integer transform is applied in the sub-band domain of a hybrid filter bank, i.e. a hybrid filter bank as used in audio coding standards like mp3.

The lossless transmission of the sub-band signals can be interpreted as a de-correlation in frequency domain. A spectral residuum is formed by subtracting the quantised spectral coefficients from the original spectral coefficients. The spectral residuum is coded losslessly (lossless coding FD 16). This might be done optionally in a scalable manner to provide intermediate audio qualities (cf. EP06113596 and EP06113576 and optional extension 4 below).

Due to the the rounding/quantisation step 12 before the integer transform 13 and due to possible non-perfect reconstruction characteristics of the sub-band filter bank 11, a residuum in time domain is to be calculated by subtracting the inverse sub-band filtered signals 18 (after the rounding/quantisation step) from the delayed original PCM input data. This residuum in time domain (temporal residuum) is losslessly encoded within the lossless coding TD block 19.

Here an optional time domain de-correlation by linear prediction filtering might be applied as described in EP06113596 (cf. *optional extension* 5 below).

The lossy encoded bit stream and the encoded (integer) spectral and temporal residua may be multiplexed to form a single bit stream or to form two streams (lossy coded stream and lossless extension carrying the residua) or to form three streams, the lossy coded stream, the coded spectral residuum stream and the coded temporal residuum stream.

At decoder side in Fig. 2, the encoded bit stream S_{DEC} enters a de-multi-plexer 20, which outputs a lossy encoded bit stream, a lossless encoded FD bit stream and a lossless encoded TD bit stream. The lossy encoded bit stream passes through a decoding block or step 24 (that regains the quantised values from the index values representing the quantised values, i.e. the second output signal of quantiser 14), a first adder 25, an inverse integer transform block or step 23 and an interpolator and inverse sub-band filter bank block or step 21 to a first input of a second adder 28. The lossless encoded FD bit stream passes through a lossless decoder FD block or step 26 to the second input of the first adder. The lossless encoded TD bit stream passes through a lossless decoder TD block or step 29 and a corresponding delay 27 to the second input of the second adder, which outputs the decoded lossy PCM signal S_{PCM}.
In this lossless decoder the full lossy, spectral and temporal residua data are de-packed and decoded. The spectral residuum is added to the decoded lossy data in frequency domain and the inverse integer transform 23 is applied. Note that the result of the inverse integer transform will exactly be the quantised sub-band signals as computed at the encoder, owing to the perfect integer reconstruction properties of the reversible integer transform and spectral residuum coding scheme. After these data (i.e. the quantised sub-band signals of the first part of the hybrid filter bank 11) have been restored, the inverse sub-band filter bank 21 is applied to reconstruct a time signal. The decoded and delayed temporal residuum is added to that time signal to reconstruct a PCM signal S_{PCM} that is mathematically identical to the originally encoded PCM samples S_{PCM}.

At last two steps of intermediate quality may be reproduced in special applications: The full and perfect reconstruction will apply both residua. A one step lower but perceptually lossless quality can be created by only applying the spectral residuum, neglecting the temporal residuum. A lossy quality might be created by decoding only the lossy coded stream, using a conventional standard-conform lossy decoder. Further intermediate quality levels might be created by only applying parts of the spectral residuum data.

In the following figures, equal reference signs mean equal functions or blocks or signals, respectively.

### First preferred embodiment

The preferred embodiments will use the well-known mp3 standard as the embedded lossy core codec, the encoding part of which is shown in Fig. 3. The original input signal S_{PCM} passes through a polyphase filter bank & decimator 503, a segmentation & MDCT 504 and a bit allocation and quantiser 505 to multiplexer 507. Input signal S_{PCM} also passes through an FFT stage or step 501 to a psycho-acoustic analysis 502 which controls the segmentation (or windowing) in step/stage 504 and the quantisation 505. The bit allocation and quantiser 505 also provides side information 515 that passes through a side info encoder 506 to multiplexer 507 which outputs signal 517. The mp3 standard applies nonuniform (i.e. non-integer) quantisation of the MDCT transform coefficients.

The first embodiment encoder in Fig. 4 includes the mp3 standard encoder of Fig. 3. However, the embedded mp3 encoder has been modified in the following manner:
The sub-band signals 512 from polyphase filter bank & decimator 503 are quantised (performing a rounding) and the original MDCT transform in block or step 504 of the individual sub-band signals has been replaced by an integer MDCT (Int-MDCT) transform 504. The integer MDCT approximates the numerical behavior of the original non-integer MDCT transform to guarantee that the embedded mp3 bit stream, produced by the Fig. 4 encoder, can be decoded by any standard-conform mp3 decoder without quality degradation.
In addition to the modified mp3 encoder, the inventive encoder signal processing comprises lossless encoding schemes for two error signals: in frequency domain and in time domain. In frequency domain, the quantised transform coefficients (obtained from the mp3 bit stream 514) are rounded in an inverse quantiser rounding block or step 521 to obtain integer values which are subtracted from the original integer MDCT transform coefficients 513 in a first subtractor 522. The resulting integer error values are encoded losslessly in a lossless encoding FD (frequency domain) block or step 523 and are multiplexed (by MUX 507) into the bit stream. In the time domain, the quantised (rounded) sub-band signals are fed into an interpolation and sub-band filter bank block 525, and the resulting time domain signal is subtracted in a subtractor 526 from the correspondingly delayed (by delay 524) original PCM samples S_{PCM}. The resulting time domain error signal is time domain de-correlated optionally (time domain de-correlator 527, see below), encoded losslessly (by lossless encoding TD block or step 528) and multiplexed (by MUX 507) into the bit stream. Multiplexer 507 outputs the corresponding encoded bit stream 517. The sub-band filter bank 525 is implemented in a platform-independent manner.
Essentially, in the first embodiment lossless decoder of Fig. 5, all the steps from the encoder block diagram are reversed. The received encoded bit stream 517 is demultiplexed in DEMUX 301. The MDCT coefficients 215 from the embedded mp3 bit stream are decoded in an 'inverse' quantiser block or step 217 and rounded in a rounding block or step 221 to get integer values 222. The side information is decoded in a side info decoder block or step 306 and controls inverse quantiser 217. The frequency domain residuum 243 is decoded in a lossless decoding FD block or step 305 and added in a first adder 261 to obtain the full integer MDCT coefficients. After applying an inverse integer MDCT transform 308, the sub-band signals 226 are fed into a interpolation and poly-phase synthesis filter bank 232. In the upper path of Fig. 5, the time domain residuum 240 is decoded in a lossless decoding TD block or step 302, optionally correlated in an inverse TD correlation block or step 303 (i.e. the inverse of the optional TD de-correlation 527), and finally added in a second adder 262 to the output signal of the poly-phase synthesis filter bank 232 to obtain the original PCM samples S_{PCM}.
Advantageously, any standard-conform mp3 decoder can decode the embedded mp3 bit stream.

### Second preferred embodiment

In the encoder in Fig. 6, the lower part of the encoder block diagram includes an unmodified, conventional and standard-conform mp3 encoder, cf. Fig. 3. In parallel to the segmentation and MDCT transform block 504 of the embedded mp3 encoder, the sub-band signals 512 (output of the poly-phase filter bank and decimation block 503) are rounded in a rounding block or step 520 to get integer values and are then fed into a segmentation and integer MDCT block 529 and an interpolation and sub-band filter bank block 525. The output of block 529 is input to a first subtractor 522. blocks/steps 521 to 528 have the same meaning and operation like in Fig. 4.
The difference to the first preferred embodiment is essentially that the integer MDCT transform is computed in parallel to the conventional MDCT instead of replacing it. The second embodiment has the advantage that the mp3 part of the bit stream is obtained by a fully standard-conform and conventional mp3 encoder. That is, there is no danger that the quality of the embedded mp3 bit stream is degraded by any approximation error of the rounding step plus the integer MDCT, compared to the normal MDCT.

In the remainder (blocks/steps 521 to 528) of the encoder block diagram the signal flow includes lossless encoding schemes for two error signals, both in frequency domain and in time domain. In frequency domain, the quantised transform coefficients (obtained from the mp3 bit stream) are rounded to obtain integer values and subsequently subtracted from the integer MDCT transform coefficients. The resulting integer error values are encoded losslessly (in 523) and multiplexed into the bit stream. In the time domain, the quantised (rounded) sub-band signals are fed into interpolation and sub-band filter bank, and the resulting time domain signal is subtracted from the original PCM samples S_{PCM}. The time domain error signal is de-correlated optionally (see below), encoded losslessly (in 528) and multiplexed into the bit stream. The sub-band filter bank is implemented in a platform-independent manner.

The decoder for the second embodiment is identical to the first embodiment decoder.

### Optional extension 1: applying gain before rounding the sub-band signals

To reduce the quantisation error produced by rounding the sub-band signals, a gain factor g can be applied before the rounding operation. To convert the rounded values back to the original domain the inverse gain factor 1/g is to be applied after the rounding. The required scaling is shown for the encoder in Fig. 7 and for the decoder in Fig. 8, respectively. The encoder shown in Fig. 7 is an enhanced version of the encoder in Fig. 4 with additional use of these gain factors.

In Fig. 7, the depicted blocks have essentially the same function or operation like the corresponding blocks in Fig. 4. The sub-band signals 206 are multiplied in a first multiplier 223 by a gain factor g. After the rounding operation 225, integer-valued sub-band samples 226 are obtained that can be processed by the integer MDCT 248. To obtain the reconstruction error (i.e. the time-domain residual) of the poly-phase filter bank 232, the rounded sub-band samples 226 are to be divided by g in a first divider 230. Thus, the resulting samples 231 are quantised versions of the original sub-band samples 206. The quantised sample values are multiples of 1/g. By choosing a greater value of g, the quantisation error can be reduced. Following the integer MDCT 248, the integer-valued spectral values 229 are also to be divided by g in a second divider 249 to continue the processing as in a standard mp3 encoder. The quantised and 'inverse' quantised spectral values 255 need to be put back in the integer domain. Therefore, these values are multiplied in a second multiplier 219 by the factor g and are rounded in rounding block or step 221. The resulting values 257 represent the quantised spectral data in the integer domain and are subtracted in a first subtactor 247 from the output signal 229 of the integer MDCT 248 to produce the frequency-domain residual 258. The remainder of the processing is like in Fig. 4.

In the corresponding decoder in Fig. 8, also the use of the gain factor g is to be taken into account. After decoding of the spectral data ('inverse' quantiser 217 and side info decoder 306), the quantised values are multiplied in multiplier 219 by factor g and are rounded in a rounding block or step 221 to integer as in the encoder (219, 221). After adding the decoded frequency-domain residual 371, which is identical to signal 258 in the encoder, and applying the inverse integer MDCT 308, a rescaling using factor 1/g is carried out in divider 309 in order to convert the sub-band samples into the original domain. The resulting samples 231 are identical to that of the output of the synthesis filter bank 205 in the encoder. The remainder of the processing is like in Fig. 5.

### Optional extension 2: decoding of lossy version (mp3 decoder)

Because the full bit stream of the proposed lossy based lossless coding scheme comprises an embedded standard-conform mp3 bit stream, conventional mp3 decoding can be applied. In the corresponding decoder signal flow depicted in Fig. 9, the parts of the bit stream that describe the time domain residual 240 and the frequency domain residual 243 are discarded. The discarding operation can take place upstream the decoder as well, e.g. in a transmission network. The blocks or steps 301, 306, 217 and 232 are identical to the corresponding blocks or steps in Fig. 5. However, an inverse MDCT block or stage 3081 may be used instead of an inverse integer MDCT block or stage 308.

### Optional extension 3: decoding of higher quality lossy version

By combining the information from the embedded mp3 bit stream and the frequency domain de-correlation, a higher quality, yet lossy, version of the audio content can be decoded. In the signal flow shown in Fig. 10, compared to the full lossless decoder in Fig. 5, the information on the time domain residual 240 is discarded. The discarding operation can take place upstream the decoder as well, e.g. in a transmission network.
Because this optional decoder will not render lossless PCM samples, it is not necessary (but possible) to use an inverse integer MDCT 308 instead of an inverse MDCT 3081 in front of the interpolation & poly-phase filter bank 232.

### Optional extension 4: layered structure for encoding the frequency domain residual

The information on the frequency domain residual 258 may be encoded using a multi-layered bit stream structure. For example, the bit plane arithmetic coding principle known from the MPEG SLS draft standard or a similar scheme may be applied. Thereby, in combination with the high quality decoder according to Fig. 10, a fully scalable coding scheme can be realised with fine granularity of the bit rate (and quality) steps.

### Optional extension 5: de-correlation of the time domain residual

In connection with Fig. 4, Fig. 5 and Fig. 6 the possibility to apply de-correlation of the time domain residual signal at encoder side and corresponding inverse de-correlation of the time domain residual signal at decoder side has been mentioned above. Fig. 11 shows which functions may be inside block 527 (left side) and block 303 (right side).
In the TD de-correlation encoder (Fig. 11, left side), a linear prediction filter is applied to the time domain residual. The prediction signal is subtracted from that residual to remove any remaining short term correlation. The prediction filter coefficients are adapted to the signal characteristics by analysing information from the lossy encoder and/or from the frequency domain de-correlation block of the codec core, and, optionally, the actual residual signal is analysed. Further, it may be necessary to signal information on the filter adaptation to the inverse time domain de-correlation block in the receiver or decoder. Therefore, it may be necessary to include certain information in the lossless extension of the gross bit stream.
At decoder side (Fig. 11, right side), identical coefficients for the linear prediction filter are to be computed, based on information from the preceding decoding stages (lossy decoder and/or frequency domain de-correlation) and potentially on side information received from the encoder part of the time domain de-correlation scheme. The coefficients are applied in a certain manner to reverse the prediction filtering effect obtained at the transmitter side, thus producing the correlated time domain residual.
Instead of using feed-forward linear prediction filtering at the encoder, other prediction schemes may be applied, like feed-backward structures or a mixture of feed-forward and feed-backward structures.

Advantageously, the invention achieves lossless coding based on existing lossy audio coding schemes with hybrid filter banks, like mp3. The only non-trivial signal processing block that should have a platform-independent implementation is the poly-phase synthesis filter bank.

The first and second embodiments have specific advantages: the first embodiment allows for low-complexity implementation of the encoder because only one set of (integer) MDCT transforms is to be computed in the encoder. On the other hand, the second embodiment allows for a higher-quality version of the encoder, where the embedded mp3 bit stream is produced by an unmodified mp3 encoder, at the cost of computing two sets of MDCT transforms in parallel.

## Claims

1. Method for lossless encoding of a source signal (S_{PCM}), using a lossy encoded data stream and a lossless extension data stream which together form a lossless encoded data stream (S_{DEC}) for said source signal, said method including the steps:
- lossy encoding said source signal, using a sub-band filter bank with decimation (11), a first quantising (12), an integer transform (13) and a second quantising (14), wherein said lossy encoding provides said lossy encoded data stream,
- interpolating and inverse sub-band filter bank processing (18) the output signal of said first quantising (12);
- forming (152) a difference signal between a correspondingly delayed (17) version of said source signal and the output signal of said inverse sub-band filter bank processing (18);
- time domain lossless encoding (19) said difference signal to provide a time domain residual signal part for said lossless extension data stream, and frequency domain lossless encoding (16) the difference signal (151) between the input signal and the quantised output signal of said second quantising (14) to provide a frequency domain residual signal part for said lossless extension data stream;
- combining (10) said lossy encoded data stream and the both parts of said lossless extension data stream to form said lossless encoded data stream (S_{DEC}).

2. Apparatus for lossless encoding of a source signal (S_{PCM}), using a lossy encoded data stream and a lossless extension data stream which together form a lossless encoded data stream (S_{DEC}) for said source signal, said apparatus including:
- means being adapted for lossy encoding said source signal, using a sub-band filter bank with decimation (11), a first quantising (12), an integer transform (13) and a second quantising (14), wherein said lossy encoding provides said lossy encoded data stream;
- means (18) being adapted for interpolating and inverse sub-band filter bank processing the output signal of said first quantising (12);
- means (152) being adapted for forming a difference signal between a correspondingly delayed (17) version of said source signal and the output signal of said inverse sub-band filter bank processing (18),
- means (19, 16) being adapted for time domain lossless encoding said difference signal to provide a time domain residual signal part for said lossless extension data stream, and for frequency domain lossless encoding the difference signal (151) between the input signal and the quantised output signal of said secong quantising (14) to provide a frequency domain residual signal part for said lossless extension data stream;
- means (10) being adapted for combining said lossy encoded data stream and the both parts of said lossless extension data stream to form said lossless encoded data stream (S_{DEC}).

3. Method for decoding a lossless encoded source signal (S_{ENC}) data stream, which data stream was encoded using the method according to claim 1, said decoding method including the steps:
- de-multiplexing (20) said lossless encoded source signal data stream to provide a lossy encoded data stream and a time domain residual signal part and a frequency domain residual signal part for the lossless extension data stream;
- lossy decoding said lossy encoded data stream, using a quantising decoder (24), an inverse integer transform (23) and an interpolation and sub-band filter bank (21);
- frequency domain lossless decoding (26) said frequency domain residual signal part and combining (25) the output signal with the corresponding output signal of said quantising decoder (24), and time domain lossless decoding (29) said time domain residual signal part and combining (28) the correspondingly delayed (27) output signal with the output signal of said interpolation and sub-band filter bank (21), so as to reconstruct said source signal (S_{PCM}).

4. Apparatus for decoding a lossless encoded source signal (S_{ENC}) data stream, which data stream was encoded using the method according to claim 1, said apparatus including:
- means (20) being adapted for de-multiplexing said lossless encoded source signal data stream to provide a lossy encoded data stream and a time domain residual signal part and a frequency domain residual signal part for the lossless extension data stream;
- means (24, 23, 21) being adapted for lossy decoding said lossy encoded data stream, using a quantising decoder, an inverse integer transform and an interpolation and sub-band filter bank;
- means (26, 25, 29, 27, 28) being adapted for frequency domain lossless decoding said frequency domain residual signal part and combining the output signal with the corresponding output signal of said quantising decoder, and for time domain lossless decoding said time domain residual signal part and combining the correspondingly delayed output signal with the output signal of said interpolation and sub-band filter bank, so as to reconstruct said source signal (S_{PCM}).

5. Method according to claim 1, or apparatus according to 2, wherein:
- said first quantising (12) is a rounding (520);
- said second quantising (14) includes a bit allocation (505) ;
- said input signal of said second quantising (14) passes through an inverse quantiser rounding (521) before said-difference signal (151, 522) is formed.

6. Method according to claim 1, or apparatus according to 2, wherein:
- said first quantising (12) is a rounding (520), wherein said integer transform (13) is a segmentation and MDCT (504) and the output of said rounding is not fed to said segmentation and MDCT (504) but is also fed to a segmentation and integer MDCT (529) the output signal of which forms one of the inputs of said difference signal (151, 522);
- said second quantising (14) includes a bit allocation (505) ;
- said input signal of said second quantising (14) passes through an inverse quantiser rounding (521) before said-difference signal (151, 522) is formed.

7. Method according to claim 3, or apparatus according to 4, wherein:
- said quantising decoder (24, 217) includes a corresponding rounding (221).

8. Audio signal that is encoded according to the method of one of claims 1, 5 or 6.

9. Storage medium, for example an optical disc, that contains or stores, or has recorded on it, a digital signal encoded according to the method of one of claims 1, 5 or 6.
